# EUROPEAN PATENT SPECIFICATION

(11) **EP 2 656 401 B1**
(45) Date of publication and mention of the grant of the patent: **15.04.2015**
(21) Application number: 11817219.6
(22) Date of filing: 21.12.2011
(51) Int. Cl.: H01L 31/18

(54) **METHOD FOR HETEROJUNCTION INTERFACE PASSIVATION**
VERFAHREN ZUR GRENZFLÄCHENPASSIVIERUNG EINES HETEROÜBERGANGS
PROCÉDÉ POUR LA PASSIVATION D'UNE INTERFACE À HÉTÉROJONCTION

(30) Priority: 22.12.2010 US 201061426453 P
(43) Date of publication of application: 30.10.2013
(73) Proprietor: IMEC, 3001 Leuven (BE)
(72) Inventor: KUMAR, Arul, Chandigarh 160009 (IN); BEARDA, Twan, B-2800 Mechelen (BE); GOUGAM, Adel, B-3012 Wilsele (BE)
(74) Representative: Bird Goën & Co
(86) International application number: PCT/EP2011/073691
(87) International publication number: WO 2012/085155

(56) References cited:
- EP-A2- 1 113 505
- KORTE L ET AL: "Advances in a-Si:H/c-Si heterojunction solar cell fabrication and characterization", SOLAR ENERGY MATERIALS AND SOLAR CELLS, ELSEVIER SCIENCE PUBLISHERS, AMSTERDAM, NL, vol. 93, no. 6-7, 1 June 2009 (2009-06-01) , pages 905-910, XP026093533, ISSN: 0927-0248, DOI: 10.1016/J.SOLMAT.2008.10.020 [retrieved on 2008-12-11]
- LI T. A. ET AL: "Thermal Stability Of Microwave PECVD Hydrogenated Amorphous Silicon As Surface Passivation For N-Type Heterojunction Solar Cells", PROCEEDINGS OF THE 22ND INTERNATIONAL EU-PVSE CONFERENCE, HELD IN MILAN, ITALY, 3 - 7 SEPTEMBER 2007, 3 September 2007 (2007-09-03), pages 1326-1331, XP040513218, ISBN: 978-3-936338-22-5
- MISHIMA T ET AL: "Development status of high-efficiency HIT solar cells", SOLAR ENERGY MATERIALS AND SOLAR CELLS, ELSEVIER SCIENCE PUBLISHERS, AMSTERDAM, NL, vol. 95, no. 1, 28 April 2010 (2010-04-28) , pages 18-21, XP027476522, On-Line ISSN: 0927-0248, DOI: 10.1016/J.SOLMAT.2010.04.030 [retrieved on 2010-04-28]

## Description

### Field of the disclosure

This disclosure relates to methods for heterojunction interface passivation, for example in heterojunction photovoltaic cells.

### Background of the disclosure

In a process for fabricating a-Si:H/c-Si heterojunction photovoltaic cells, a p-type (or n-type) a-Si:H emitter layer is deposited on an n-type (or p-type) c-Si substrate (base layer) to form a p/n (n/p) heterojunction. The deposition of the doped a-Si:H layer can for example be done using plasma enhanced chemical vapor deposition (PECVD). The junction characteristics and thus the current-voltage characteristics of photovoltaic cells comprising such a heterojunction are negatively affected by a large amount of defects at the doped a-Si/c-Si heterojunction interface. As a result, a high *V_{oc}* (open circuit voltage) cannot be achieved.

In order to obtain a better cell performance, the charge carrier recombination at the interface between the doped a-Si:H and the doped c-Si needs to be reduced. This is commonly done by providing a thin intrinsic (undoped) a-Si:H layer in between the two doped layers. By providing a thin high-quality intrinsic a-Si:H layer in between the doped a-Si:H layer and the crystalline silicon, interface defects can be passivated. Although the recombination velocity is reduced by providing a thicker intrinsic layer, this intrinsic layer should be as thin as possible in order to minimize resistive as well as optical losses in the photovoltaic cell. For a good short circuit current density (*J_{sc}*) the i-a-Si:H needs to be as thin as possible (thickness about 2 nm to 4 nm). On the other hand, on decreasing the thickness of the i-a-Si:H the charge carrier recombination velocity also increases drastically. Good passivation of interface defects using thin intrinsic layers is usually obtained by performing an anneal for up to 60 min at a temperature of typically 200ºC in forming gas after the a-Si:H depositions.

At the rear side of a-Si:H/c-Si heterojunction photovoltaic cells, a doped a-Si layer can be provided for forming a Back Surface Field (BSF). For example, on the rear side of an n-type c-Si substrate, an n⁺ a-Si:H layer can be provided and vice versa, on the rear side of a p-type c-Si substrate, a p⁺ a-Si:H layer can be provided.

The interface recombination velocity in such BSF structures can also be reduced by providing an intrinsic a-Si:H layer at the interface between the doped a-Si and the c-Si. Although the recombination velocity is reduced by providing a thicker intrinsic layer, this intrinsic layer should be as thin as possible in order to reduce resistive losses in the photovoltaic cell. Good passivation using thin intrinsic layers is usually obtained by performing an anneal for up to 60 min at a temperature of typically 200ºC in forming gas after the a-Si:H depositions.

A fabrication method for a heterojunction solar cell is known from Korte L et al., "Advances in a-Si:H/c-Si heterojunction solar cell fabrication and characterization", published in Solar Energy Materials and Solar Cells, vol. 93, p. 905-910, wherein a doped amorphous silicon thin film emitter is deposited on a crystalline silicon substrate surface, with or without a 3-10nm thick intrinsic amorphous silicon interlayer, followed by a post-deposition hydrogen plasma treatment to reduce recombination at the a-Si:H/c-Si interface.

A further heterojunction solar cell fabrication method is disclosed in EP 1 113 505 A2, wherein an intrinsic hydrogenated amorphous semiconductor layer is formed on a crystalline substrate and then exposed to a dopant gas plasma, thereby forming a doped sub-layer extending up to a certain depth from the surface of said amorphous semiconductor layer.

### Summary of the disclosure

It is an object of embodiments of the present disclosure to provide a method for heterojunction interface passivation by providing a thin passivation layer at the heterojunction interface, wherein the method can be less time consuming than prior art methods and wherein the method results in a better passivation quality (lower charge carrier recombination velocity) than prior art passivation methods. The thickness of the thin passivation layer is selected such that an electrical current can flow through the heterojunction without a significant increase of the junction resistance. The thickness of the passivation layer is preferably less than 100 nm, e.g. less than 10 nm. For example, the thickness of the passivation layer can be between 1 nm and 10 nm, e.g. between 2 nm and 7 nm.

A method of the present disclosure can advantageously be used for heterojunction interface passivation of photovoltaic cells. For example, the method can be used for emitter junction passivation of photovoltaic cells having a crystalline silicon base layer of a first doping type and an amorphous silicon emitter layer of a second doping type opposite to the first doping type. The thin passivation layer can be a thin hydrogenated amorphous silicon layer at the interface between the base layer and the emitter layer. For example, the method can also be used for rear side heterojunction passivation of photovoltaic cells having a crystalline silicon base layer of a first doping type and a heavily doped amorphous silicon layer of the first doping type for forming a Back Surface Field layer. The thin passivation layer can be a thin hydrogenated amorphous silicon layer at the interface between the base layer and the heavily doped Back Surface Field layer.

The above objective is accomplished by a method according to the present disclosure.

Particular and preferred aspects of the disclosure are set out in the accompanying independent and dependent claims. Features from the dependent claims may be combined with features of the independent claims as appropriate and not merely as explicitly set out in the claims.

The present disclosure provides a method for heterojunction interface passivation, the method comprising: providing a thin passivation layer at the heterojunction interface; and performing a hydrogen plasma treatment after providing the thin passivation layer. The heterojunction can for example be a junction between a crystalline silicon substrate and a doped amorphous silicon layer, and the passivation layer can be a thin amorphous silicon layer, e.g. a thin intrinsic hydrogenated amorphous silicon (i-a-Si:H) layer. However the present disclosure is not limited thereto and other suitable passivation layers can be used, such as for example layers comprising SiON, SiOₓ, SiC, or any other suitable material known to a person skilled in the art.

Providing the thin passivation layer can comprise growing the thin passivation layer on a substrate by means of a CVD (Chemical Vapour Deposition) method, preferably in the presence of a plasma. For example, growing the thin passivation layer can be done in a PECVD (Plasma Enhanced CVD) chamber, a remote plasma CVD chamber, a MWCVD (Microwave Assisted CVD) chamber, an ECR (Electron Cyclotron Resonance) plasma chamber or any suitable deposition chamber wherein a plasma is used.

In a first aspect of the present disclosure, providing a thin a-Si:H passivation layer comprises growing the passivation layer on the substrate using a silicon precursor gas such as for example SiH₄, SiH₂Cl₂, SiHCl₃, or SiCl₄ as a silicon source. Providing the thin a-Si:H passivation layer can for example be done at a temperature in the range between 100ºC and 200ºC, or between 100°C and 195°C, or between 100°C and 190C, at a pressure in the range between 0.1 Torr (13.3 Pa) and 2 Torr (266.6 Pa). However, the present disclosure is not limited thereto and other suitable temperatures, pressures and/or gas mixtures known to a person skilled in the art can be used. These parameters also depend on the type of CVD reactor and on the geometrical dimensions of the CVD reactor used. Suitable parameter ranges can be determined experimentally. Elements such as CO₂, B₂H₆ or PH₃ can be added during a-Si:H layer growth.

In a second aspect of the present disclosure, providing a thin a-Si:H passivation layer comprises growing the passivation layer on the substrate using a silicon precursor such as for example SiH₄, SiH₂Cl₂, SiHCl₃, or SiCl₄ as a silicon source, wherein the silicon precursor is diluted in H₂. The ratio between the silicon precursor and the hydrogen is preferably in the range between 1:2 and 1:6. Providing the thin a-Si:H passivation layer can for example be done at a temperature in the range between 100ºC and 200ºC, at a pressure in the range between 0.3 Torr (40 Pa) and 5 Torr (666.6 Pa). However, the present disclosure is not limited thereto and other suitable temperatures, pressures and/or gas mixtures known to a person skilled in the art can be used. These parameters also depend on the type of CVD reactor and on the geometrical dimensions of the CVD reactor used. Suitable parameter ranges can be determined experimentally. It is an advantage of using a diluted silicon precursor according to the second aspect of the present disclosure that it allows to obtain a least disordered a-Si:H layer (close to microcrystalline silicon) and with the least amount of dangling bonds and the least amount of strained Si-Si bonds, even for very thin layers (e.g. 5 nm thick layers).

The hydrogen plasma treatment can be performed in a PECVD chamber, e.g. the chamber wherein the thin passivation layer has been provided. The hydrogen plasma treatment can for example be done at a temperature in the range between 100ºC and 200ºC, at a pressure in the range between 0.1 Torr (13.3 Pa) and 5 Torr (666.6 Pa), using H₂. However, the present disclosure in not limited thereto and other suitable temperatures or pressures known to a person skilled in the art can be used. These parameters also depend on the type of CVD reactor and on the geometrical dimensions of the CVD reactor used. Suitable parameter ranges can be determined experimentally.

The method according to aspects of the present disclosure can advantageously be used for interface passivation of heterojunction photovoltaic cells comprising a crystalline base region and an amorphous emitter layer and/or an amorphous BSF layer. The passivation method can be used for interface passivation at the emitter side (front side) of the photovoltaic cells and/or at the BSF side (rear side) of the photovoltaic cells. The front side is the side to the photovoltaic cell which is preferably directed towards a light source such as the sun when in use. The rear side is opposed to the front side.

When using a method of the present disclosure for heterojunction interface passivation, a further step in the process after providing the passivation layer is forming the heterojunction by providing an additional semiconductor layer. For example, in a process for forming a silicon heterojunction photovoltaic cell, after providing a thin i-a-Si:H passivation layer, a doped a-Si:H layer can be grown on the i-a-Si:H layer, for forming an emitter layer or a BSF layer.

The hydrogen plasma treatment can be performed after providing the intrinsic amorphous silicon layer and before providing the additional layer, e.g., doped amorphous silicon layer. In an alternative example not covered by the claims, the hydrogen plasma treatment can be performed after providing the additional layer, e.g. doped amorphous silicon layer. This may have a beneficial effect on the additional layer. The hydrogen plasma treatment can also be performed twice: a first time after providing the intrinsic amorphous silicon layer and before providing the additional layer, e.g. doped amorphous silicon layer, and a second time after providing the additional layer, e.g. doped amorphous silicon layer.

The one or more hydrogen plasma treatments can also be performed at the same time for two intrinsic amorphous silicon layers which may be provided on opposite main surfaces of the silicon substrate. Alternatively, one or more plasma treatments can be performed independently on the front side and on the backside. The hydrogen plasma conditions can thereby be optimised for front side and rear side independently, and can thus be different on both sides. The plasma conditions can for instance be tuned in function of the layer thickness.

It is an advantage of a method according to aspects of the present disclosure that it provides an integrated approach, wherein the passivation layer deposition and the hydrogen plasma treatment can be performed in the same chamber, for instance subsequently. The method of the present disclosure can be less time consuming than prior art methods wherein a Forming Gas anneal is performed for improving the heterojunction interface passivation.

It is an advantage of a method according to aspects of the present disclosure that it provides a degree of freedom when initially providing the thin passivation layer, the quality of which can, at least partially, be corrected afterwards by the plasma treatment. It will be appreciated by the skilled person that controlling the properties and thus quality of the thin passivation layer is crucial for producing optimised and optimally performing photovoltaic cells, and that aspects of the present invention make it easier to control these properties. For instance, it is an advantage of methods according to aspects of the present invention, that the overall temperature budget for processing a photovoltaic cell can be reduced significantly. Deposition of the thin passivation layer can for instance occur at relatively low temperatures, and can then be followed by a short plasma treatment to still arrive at a predetermined or sufficient quality of the thin passivation layer, such that the overall temperature budget can be smaller for a similar end product.It is an advantage of a method of the present disclosure that it may lead to a better heterojunction interface passivation as compared to prior art methods. It may lead to good passivation properties for very thin passivation layers.

Summarizing again, a method for fabricating a heterojunction photovoltaic cell is described, comprising
- providing a crystalline silicon substrate,
- providing a thin passivation layer on a first main surface of the substrate;
- performing a plasma treatment, comprising treating the thin passivation layer with a hydrogen plasma,
- providing a second layer on the thin passivation layer, the second layer comprising amorphous silicon, wherein the plasma treatment
is performed before providing said second layer.

The plasma treatment can be performed before providing the second layer.

The plasma treatment can be performed after providing the second layer.

A first plasma treatment can be provided before providing the second layer and a second plasma treatment can be provided after the plasma treatment.

According to preferred embodiments, the thin passivation layer comprises intrinsic hydrogenated amorphous silicon.

According to preferred embodiments, the thin passivation layer comprises SiON and/or SiOₓ (x=1,2) and/or SiC.

Preferably, the thickness of the thin passivation layer after plasma treatment is less than 100 nm. The thickness of the thin passivation layer after plasma treatment can be less than 10 nm. The thickness of the thin passivation layer after plasma treatment can be between 1 and 10 nm.

According to preferred embodiments, providing the thin passivation layer comprises growing the thin passivation layer.

According to preferred embodiments, the growing of the thin passivation layer comprises a plasma enhanced CVD process.

According to preferred embodiments, growing the thin passivation layer by using a silicon precursor gas comprising SiH₄, SiH₂Cl₂, SiHCl₃, or SiCl₄.

According to preferred embodiments, the thin passivation layer is provided at a pressure between 0.1 Torr and 2 Torr.

According to preferred embodiments, the silicon precursor gas is diluted in H₂. The dilution ratio between the silicon precursor and the hydrogen is preferably comprised within the range 1:2 to 1:6.

According to preferred embodiments, the method comprises providing the thin passivation layer at a pressure between 0.1 Torr and 5 Torr.

According to preferred embodiments, the method comprises providing the thin passivation layer at a temperature between 100 and 200 degrees C.

According to preferred embodiments, providing the thin passivation layer on a first main surface of the substrate and performing the plasma treatment are performed within the same vacuum chamber, without breaking a vacuum in the vacuum chamber.

According to preferred embodiments, a duration of the plasma treatment is comprised within the range of 10 to 120 seconds.

According to preferred embodiments, a power density of the plasma treatment is comprised within the range of 0.01 to 0.5 W/cm².

According to preferred embodiments, the plasma power used during providing a thin passivation layer on a first main surface of the substrate is smaller than the plasma power during the plasma treatment.

Typically, the first main surface can correspond to a front surface of the photovoltaic cell, the second layer corresponding to an emitter layer of the photovoltaic cell.

The first main surface can typically correspond to a back surface of said photovoltaic cell, the second layer corresponding to a back surface field layer.

For purposes of summarizing the disclosure and the advantages achieved over the prior art, certain objects and advantages of the disclosure have been described herein above. Of course, it is to be understood that not necessarily all such objects or advantages may be achieved in accordance with any particular embodiment of the disclosure. Thus, for example, those skilled in the art will recognize that the disclosure may be embodied or carried out in a manner that achieves or optimizes one advantage or group of advantages as taught herein without necessarily achieving other objects or advantages as may be taught or suggested herein. Further, it is understood that this summary is merely an example and is not intended to limit the scope of the disclosure as claimed. The disclosure, both as to organization and method of operation, together with features and advantages thereof, may best be understood by reference to the following detailed description when read in conjunction with the accompanying drawings.

### Brief description of the drawings

Figure 1 shows measured surface recombination velocities as a function of the power density of the hydrogen plasma used in a method according to the first aspect of the present disclosure. The exposure time was 75 seconds.
Figure 2 shows measured surface recombination velocities at different times of applied hydrogen plasma in a method according to the first aspect of the present disclosure. The plasma power was 18W, corresponding to a plasma power density of 0.052 W/cm².
Figure 3 shows ε₂ curves (imaginary part of the dielectric function) for different times of H₂ plasma exposure for a plasma power density of 0.052 W/cm².
Figure 4 shows the thickness of an i-a-Si:H film as a function of the exposure time to a hydrogen plasma, for a plasma power density of 0.052 W/cm².
Figure 5 shows ε₂ curves at different powers of H₂ plasma. The exposure time was 60s.
Figure 6 shows the thickness of an i-a-Si:H film as a function of the hydrogen plasma power, for an exposure time of 60s.
Figure 7 shows measured surface recombination velocities for FZ wafers covered with a 4 nm to 5 nm thick i-a-Si:H film after hydrogen plasma treatment, for different exposure times and for different plasma powers.
Figure 8 shows the thickness of an i-a-Si:H film as a function of the exposure time to an 18 W (0.052 W/cm²) hydrogen plasma.
Figure 9 shows ε₂ curves for i-a-Si:H films deposited at various hydrogen / silane dilution ratios according to the second aspect of the present disclosure.
Figure 10 shows measured SRV values i-a-Si:H films deposited at a dilution ratio of 1:3 according to the second aspect of the present disclosure, for different hydrogen plasma exposure times.

Any reference signs in the claims shall not be construed as limiting the scope of the present disclosure.

In the different drawings, the same reference signs refer to the same or analogous elements.

### Detailed description of the disclosure

In the following detailed description, numerous specific details are set forth in order to provide a thorough understanding of the disclosure and how it may be practiced in particular embodiments. However, it will be understood that the present disclosure may be practiced without these specific details. In other instances, well-known methods, procedures and techniques have not been described in detail, so as not to obscure the present disclosure. While the present disclosure will be described with respect to particular embodiments and with reference to certain drawings, the disclosure is not limited hereto. The drawings included and described herein are schematic and are not limiting the scope of the disclosure. It is also noted that in the drawings, the size of some elements may be exaggerated and, therefore, not drawn to scale for illustrative purposes.

Furthermore, the terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the disclosure described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the disclosure described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B.

The present disclosure provides a method for heterojunction interface passivation by providing a thin passivation layer at the heterojunction interface, wherein the method is less time consuming than prior art methods and wherein the method results in a better passivation quality (lower charge carrier recombination velocity) than prior art passivation methods. The thickness of the thin passivation layer is selected such that an electrical current can flow through the heterojunction without a significant increase of the junction resistance. The thickness of the passivation layer is preferably less than 100 nm, e.g. less than 10 nm. For example, the thickness of the passivation layer can be between 1 nm and 10 nm, e.g. between 2 nm and 7 nm.

The method of the present disclosure comprises: providing a thin passivation layer at the heterojunction interface; and performing a hydrogen plasma treatment after providing the thin passivation layer. The heterojunction can for example be a junction between a crystalline silicon substrate and a doped amorphous silicon layer, and the passivation layer can for example be a thin amorphous layer, for example a thin intrinsic hydrogenated amorphous silicon (i-a-Si:H) layer.

The present disclosure is further described for embodiments wherein the passivation layer is an amorphous silicon layer. However, the present disclosure is not limited thereto and other materials such as for example SiOₓ or SiON can be used for forming the passivation layer.

In a first aspect of the present disclosure, providing a thin a-Si:H passivation layer comprises growing the passivation layer on the substrate using a silicon precursor such as for example SiH₄, SiH₂Cl₂, SiHCl₃, or SiCl₄ as a silicon source.

In a second aspect of the present disclosure, providing a thin a-Si:H passivation layer comprises growing the passivation layer on the substrate using a silicon precursor such as for example SiH₄, SiH₂Cl₂, SiHCl₃, or SiCl₄ as a silicon source, wherein the silicon precursor is diluted in H₂. The ratio between the silicon precursor and the hydrogen is preferably in the range between 1:2 and 1:6.

The method of the present disclosure can advantageously be used for interface passivation of heterojunction photovoltaic cells comprising a monocrystalline, multicrystalline or polycrystalline base region and an amorphous emitter layer and/or an amorphous BSF layer. The passivation method can be used for interface passivation at the emitter side (front side) of the photovoltaic cells and/or at the BSF side (rear side) of the photovoltaic cells.

When using a method of the present disclosure for heterojunction interface passivation, a further step in the process after providing the passivation layer is forming the heterojunction by providing an additional layer. For example, in a process for forming a silicon heterojunction photovoltaic cell, after providing a thin i-a-Si:H passivation layer a doped a-Si:H layer can be grown, for forming an emitter layer or a BSF layer.

The hydrogen plasma treatment can be performed after providing the intrinsic amorphous silicon layer and before providing the additional layer, e.g. doped amorphous silicon layer. In an alternative example not covered by the claims, the hydrogen plasma treatment can be performed after providing the additional layer, e.g. doped amorphous silicon layer. The hydrogen plasma treatment can also be performed twice: a first time after providing the intrinsic amorphous silicon layer and before providing the additional layer, e.g. doped amorphous silicon layer, and a second time after providing the additional layer, e.g. doped amorphous silicon layer.

To study the passivation effect of a H₂ plasma treatment in a method according to the first aspect of the present disclosure, experiments were performed wherein an i-a-Si:H layer was deposited on both sides of double side polished, 280 micrometer thick, n-type c-Si <100>, float zone wafers having a resistivity of 1-3 Ωcm and a bulk lifetime of more than 4 ms. The wafers were cleaned with a H₂SO₄:H₂O₂ (4:1) mixture, followed by HF:HCl:H₂O₂ (1:1:20) mixture. Finally a chemical oxide was grown on the wafers using HCl:H₂O₂:H₂O (1:1:5). Prior to the i-a-Si:H deposition an HF:HCl:H₂O₂ (1:1:20) dip was performed for 2 minutes. The time between the HF/HCl dip and the loading of the wafers in the deposition chamber was kept as short as possible. Next, the i-a-Si:H deposition was performed by means of a plasma enhanced chemical vapor deposition (PECVD) method using an RF plasma (13.56 MHz). This was followed by a H₂ plasma exposure in the same chamber, without breaking the vacuum. Table 1 gives an overview of the conditions used. The thickness of the i-a-Si:H layers was in the range between 7 nm and 8 nm.

**Table 1**

| | Temperature (°C) | Power density (W/cm²) | Pressure (Torr) | Flow rate (sccm) | | Time (seconds) |
|---|---|---|---|---|---|---|
| | | | | SiH₄ | H₂ | |
| a-Si:H | 170 | 0.05 | 0.525 (70 Pa) | 100 | 0 | 30 |
| H₂ plasma | 170 | 0.05 - 0.2 | 2 (266.6 Pa) | 0 | 200 | 30 - 120 |

However, the present disclosure is not limited to the conditions shown in Table 1. Examples of suitable ranges for the different parameters are shown in Table 2, the present disclosure not being limited thereto.

**Table 2**

| | Temperature (°C) | Power density (W/cm²) | Pressure (Torr) | Flow rate (sccm) | | Time (seconds) |
|---|---|---|---|---|---|---|
| | | | | SiH₄ | H₂ | |
| a-Si:H | 100-200 | 0.01 - 0.1 | 0.1-2 (13.3-266.6 Pa) | 10-100 | 0 | 10 - 120 |
| H₂ plasma | 100-200 | 0.01 - 0.5 | 0.1 - 5 (13.3-666.6 Pa) | 0 | 10-500 | 10 - 120 |

Spectroscopic ellipsometry was used to determine the thickness and the optical constants of the i-a-Si:H films. The Tauc-Lorentz model was used for the analysis of the raw data obtained from the ellipsometric measurements. This model allows finding the ε₂ dispersion (the imaginary part of the dielectric function). The minority carrier lifetimes were measured using Quasi Steady State Photo Conductance measurements (QSSPC). The lifetimes are reported at an excess carrier density of 10¹⁵ cm⁻³. Since FZ-Si material with high bulk lifetime was used, the effective surface recombination velocity (SRV), may be approximated by SRV= d*(2T_{eff})⁻¹, with d being the wafer thickness and T_{eff} being the effective minority charge carrier lifetime.

The thickness of the i-a-Si:H layer deposited according to the parameters shown in Table 1 was 7 nm to 8 nm. After deposition (without H₂ plasma treatment) the SRV was 15.45 cm/s. Annealing in forming gas at 250ºC for 30 minutes resulted in a decrease of the SRV to 10.86 cm/s.

Experiments were performed, wherein after deposition of the i-a-Si:H layer a hydrogen plasma treatment was performed instead of a forming gas anneal. For studying the effect of a H₂ plasma treatment on the passivation quality of the interface between the crystalline silicon substrate and the i-a-Si:H layer the hydrogen plasma power density was varied in the range between 0.05 W/cm² and 0.2 W/cm² and the time of exposure to the hydrogen plasma was varied between 30 seconds and 120 seconds (Table 1). Surface Recombination Velocities were evaluated as a function of H₂ plasma process parameters.

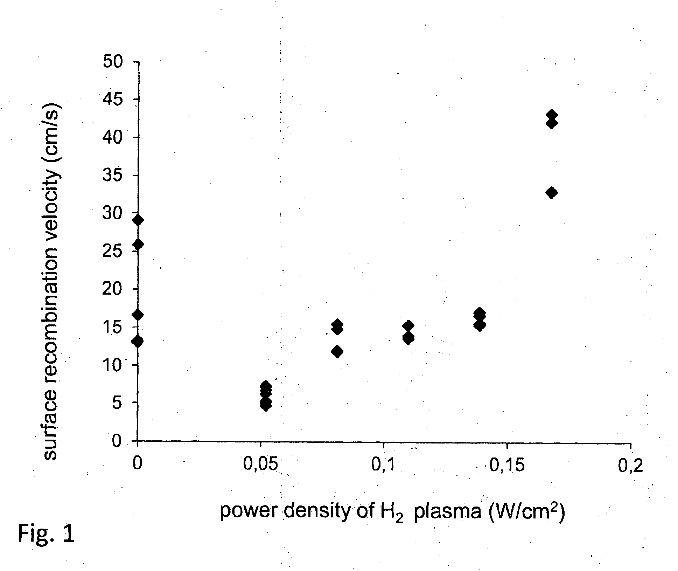

Figure 1 shows measured surface recombination velocities for different applied plasma power densities during the hydrogen plasma treatment. The time of the exposure was kept constant at 75 seconds. The points at zero power correspond to the standard conditions without H₂ plasma treatment. From the measured results it can be concluded that after deposition of the i-a-Si:H layer the SRV is in the range between 13 cm/s and 29 cm/s (different samples). After hydrogen plasma treatment the SRV is reduced, depending on the power of the hydrogen plasma. The largest reduction of the SRV is obtained for the lowest plasma power density. For example, for a plasma power density of 0.05 W/cm² (18 W) the SRV measured on one of the samples was reduced from 29.1 cm/s to 6.6 cm/s. For another sample the SRV was reduced from 15.45 cm/s to 4.7 cm/s.

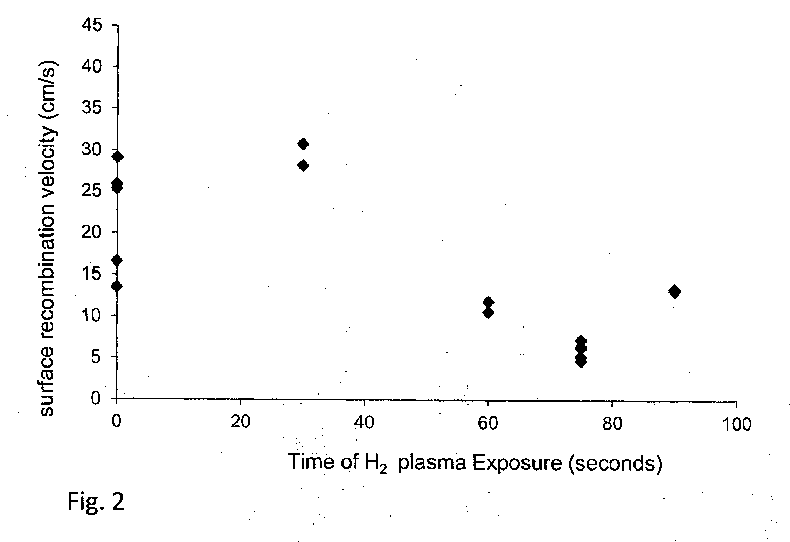

Figure 2 shows measured surface recombination velocities at different hydrogen plasma exposure times. In these experiments, the power density was kept constant at 0.05 W/cm². With the increase in time of exposure the SRV decreases up till 75 seconds and then it starts increasing.

To understand these trends of passivation quality, ellipsometric measurements were done to estimate the thickness and hydrogen content of the i-a-Si:H films.

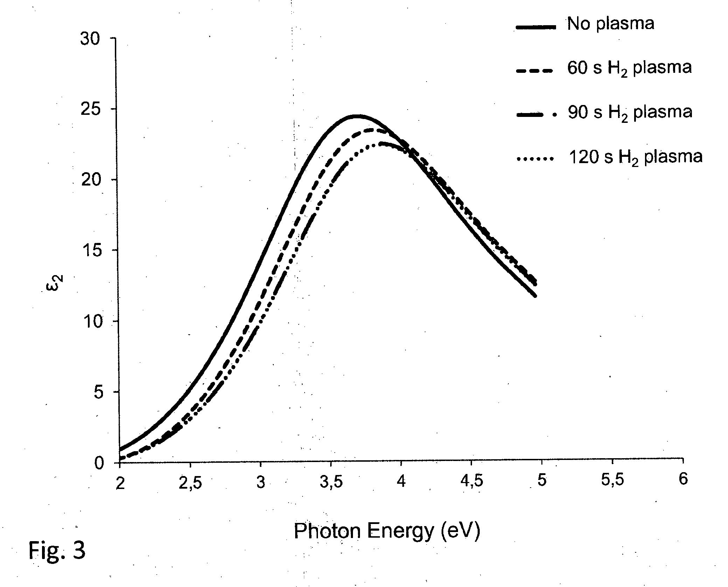

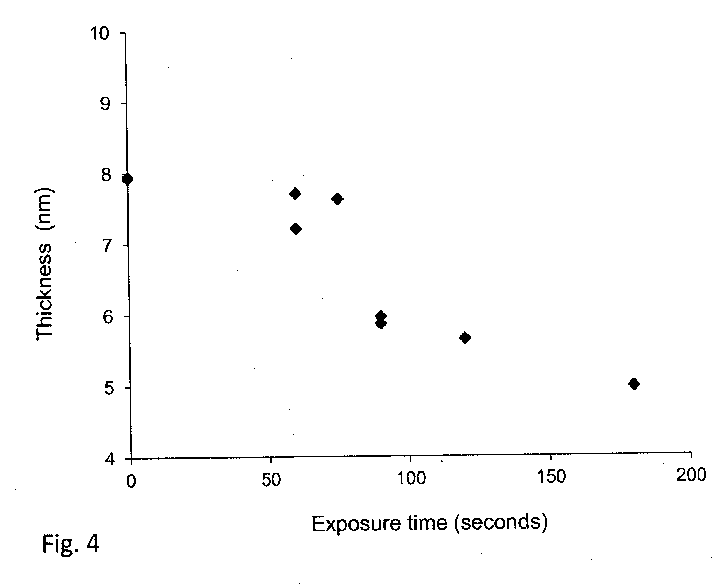

The imaginary part of the dielectric function (ε₂), of a 7 nm thick film is plotted in Figure 3 for different hydrogen plasma exposure times, for a plasma power density of 0.05 W/cm². The peak at 3.6eV is characteristic of as-deposited a-Si:H. After exposure to the H₂ plasma the peak shifts and the amplitude decreases. This decrease in amplitude mainly occurs in the first 75 seconds of H₂ plasma exposure and then becomes constant. The decrease in amplitude is attributed to an increase in hydrogen content of the film. The hydrogen content increases in the first 75 seconds, and after this a reduction in film thickness is observed. This is illustrated in Figure 4, showing the amorphous film thickness as a function of the hydrogen plasma exposure time (0.05 W/cm² plasma power density).

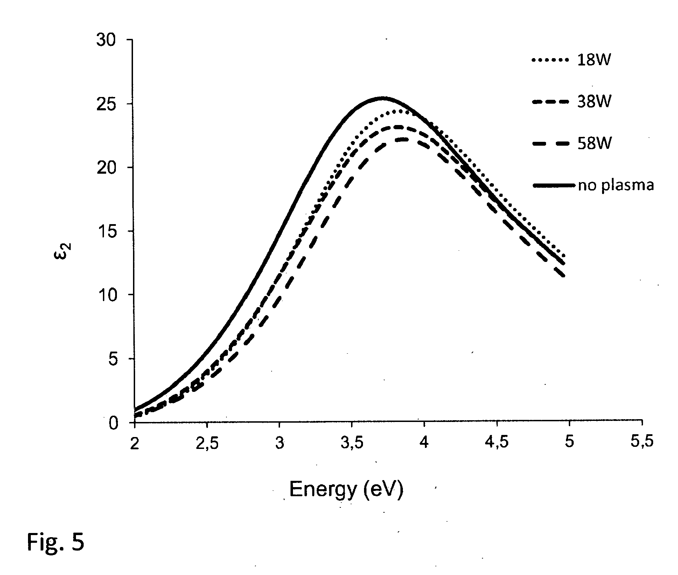

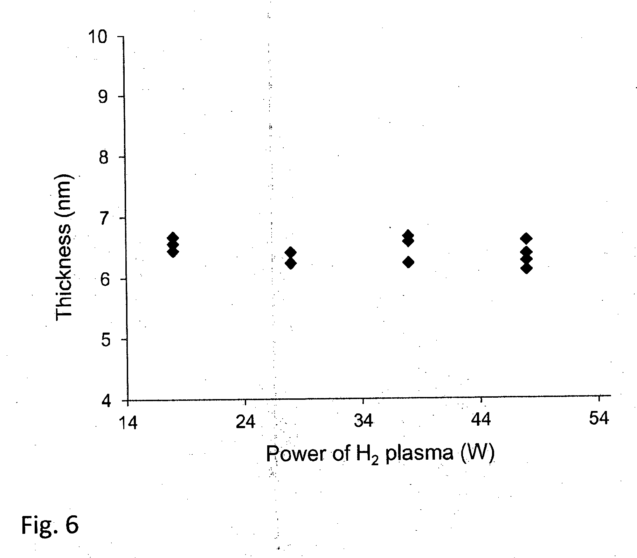

With the increase in H₂ plasma power an increase in concentration of hydrogen is observed (illustrated in Figure 5 for 60s exposure time) in the film but the thickness of the film remains constant (Figure 6, 60s exposure time).

It was seen that the passivation increased till an optimum exposure time of 75 seconds (for the conditions used in the experiments) and then dropped as the exposure time was increased. The hydrogen content of the film increases up till 75 seconds of plasma exposure and then becomes constant. After 75 seconds a decrease in film thickness is observed (Figure 4). The initial increase in passivation quality can be attributed to the increase in hydrogen content of the film, which helps passivating the dangling bonds at the surface of the c-Si substrate. After 75 seconds, even though the hydrogen content of the film is constant, the quality of the i-a-Si:H film decreases, possibly due to an increase in porosity of the film and due to thickness reduction, hence the lifetime decreases with duration of H₂ plasma exposure.

Although in the experiments an optimum exposure time of 75 seconds to the hydrogen plasma was found, this optimum exposure time can be different for other layer thicknesses, other pressures, temperatures, hydrogen flows, etc. For example, in experiments done for i-a-Si:H films with a thickness in the range between 4 nm and 5 nm an optimum hydrogen plasma exposure time of 35 seconds was found. An optimum hydrogen exposure time can be experimentally determined for other process conditions.

In the experiments, the highest lifetimes (best passivation quality) were obtained at a H₂ plasma power density of 0.05 W/cm², and then started to decrease as the power density of the H₂ plasma was increased. This reduction in lifetime may be due to an increased hydrogen induced damage to the interface, hence increasing defects density.

The measured decrease in SRV after plasma treatment was much larger as compared to values obtained after forming gas anneal. The SRV decreased from 15.45 cm/s to 4.67 cm/s in 7 nm thick i-a-Si:H using hydrogen plasma treatment while the surface recombination velocity was 10.85 cm/s when annealed at 250°C for 30 minutes.

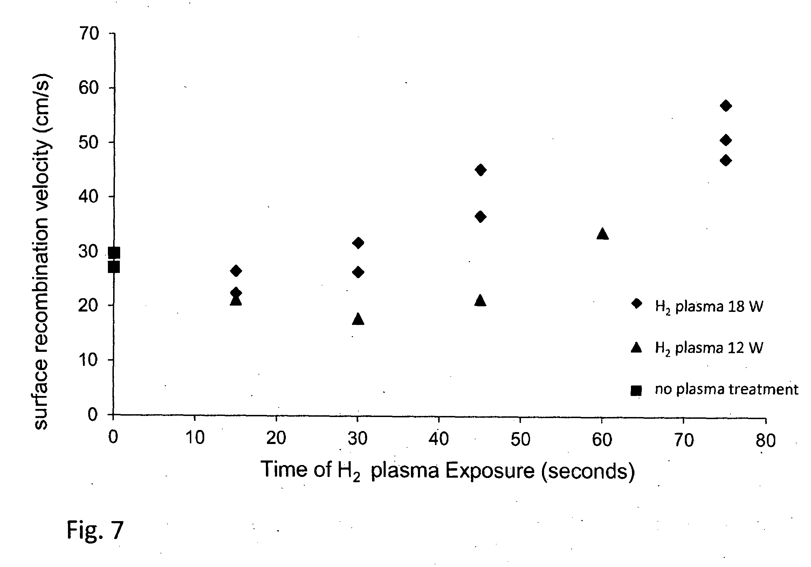

The effect of a hydrogen plasma treatment on the passivation quality of thin i-a-Si:H layers was also studied for thinner layers (thickness 4 nm to 5 nm). The deposition conditions shown in Table 1 were used, with a deposition time of 20 seconds instead of 30 seconds. The SRV values obtained for different exposure times and for different plasma powers are shown in Figure 7. As can be seen in figure 7, the SRV increased as the time of exposure was increased. Also at higher powers of H₂ plasma the SRV was higher. The trend is similar to that observed for 7 nm to 8 nm thick films, though the increase of SRV is observed for lower powers as compared to the relatively thicker films. The lowest SRV (17.8cm/s) was obtained for a treatment of 30s at 12W hydrogen plasma power. It may be possible to achieve lower SRV values at lower hydrogen plasma powers.

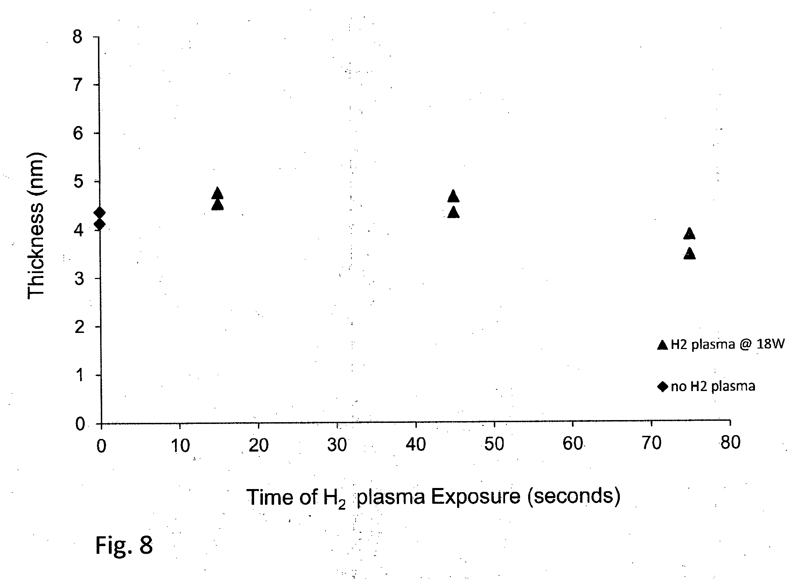

The effect of the duration (exposure time) of an 0.05 W/cm² hydrogen plasma treatment on the thickness of the i-a-Si:H layer is shown in Figure 8. It can be concluded that there is no effect on the thickness of the layer for exposure times less than 45s. For longer exposure times (e.g. 75s) a decrease in thickness is observed for the 4 nm to 5 nm thick layers. Hence the decrease in thickness occurs earlier as compared to films of thicknesses 7nm to 8nm.

To study the passivation effect of a H₂ plasma treatment in a method according to the second aspect of the present disclosure, additional experiments were performed wherein H₂ gas dilution of SiH₄ during i-a-Si:H deposition was combined with a hydrogen plasma treatment. For a better control of disorder of the a-Si layer formed, hydrogen gas was introduced with the silane gas in the chamber while depositing the i-a-Si:H thin film. The parameters used for deposition are given in table 3.

**Table 3**

| Dilution (SiH₄:H₂) | Temperature (°C) | Power (W/cm²) | Pressure (Torr) | Flow rate (sccm) | |
|---|---|---|---|---|---|
| | | | | H₂ | SiH₄ |
| 1:1 | 170 | 0.05 | 1.7 (226.6 Pa) | 50 | 50 |
| 1:3 | 170 | 0.05 | 1.7 (226.6 Pa) | 75 | 25 |
| 1:4 | 170 | 0.05 | 1.7 (226.6 Pa) | 80 | 20 |
| 1:6 | 170 | 0:05 | 1.7 (226.6 Pa) | 86 | 14 |
| 1:8 | 170 | 0.05 | 1.7 (226.6 Pa) | 89 | 11 |
| 1:10 | 170 | 0.05 | 1.7 (226.6 Pa) | 91 | 9 |

For hydrogen dilution ratios of 1:3 and 1:4 and for a deposition time of 15s, the film thickness was 7 nm to 8 nm, and the best passivation quality (lowest SRV) was obtained at these dilution ratios. For lower and higher dilution ratios the film was thinner, and the measured SRV was significantly larger. As compared to films grown according to the first aspect of the present disclosure, a slight decrease in SRV was observed for similar thickness (about 7 nm to 8 nm) for a 1:3 dilution. For example, when using a dilution ratio of 1:3 an SRV of 9.84 cm/s was measured, whereas for a film of similar thickness deposited with pure silane the SRV value was 15.45 cm/s.

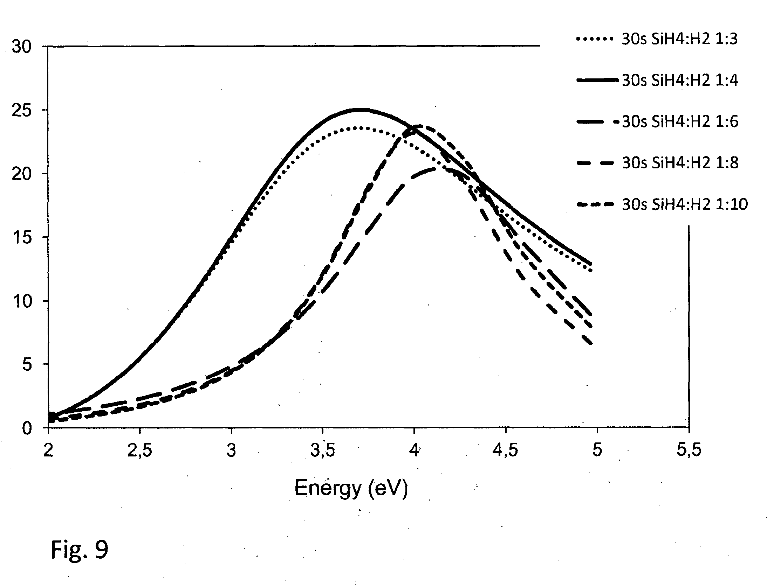

To understand the variation in thickness and passivating properties of the films deposited with hydrogen dilution the imaginary part of the dielectric function (ε₂) was measured using ellipsometry. Figure 9 shows the measured ε₂ curves for various films. It can be seen that, as the dilution is increased, there is a change in the hydrogen content of the film as well as a peak shift. For increasing dilution it is observed that the peak shifts towards higher values. This shift points towards the evolution of the film from an amorphous phase towards a micro-crystalline phase. There is an abrupt peak shift above a dilution of 1:4 (SiH₄:H₂) from about 3.6 eV to about 4.2eV. This marks a transformation from the amorphous phase to the micro crystalline phase. This peak shift towards higher energies for higher dilution ratios, coupled with the lower thicknesses observed point towards epitaxial growth at these values of dilution. A decrease in the hydrogen content of the film is observed as the film becomes more crystalline.

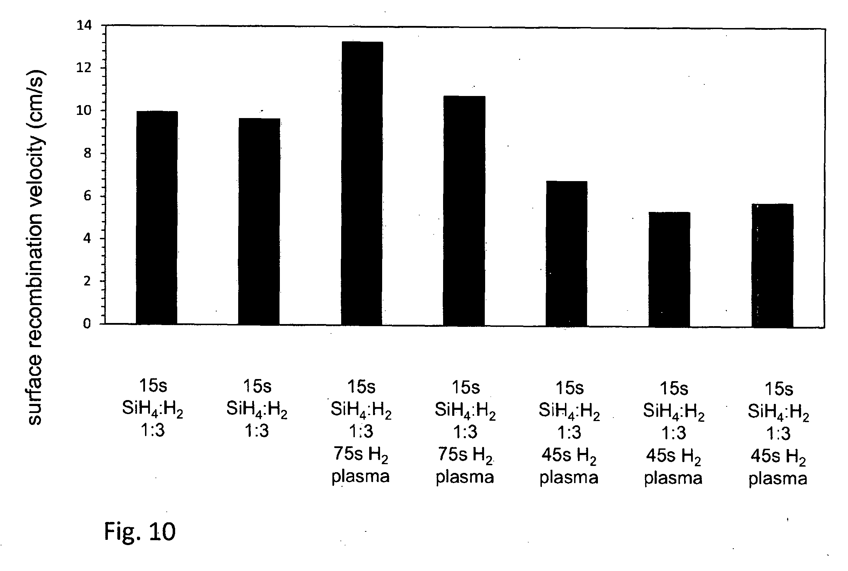

In the experiments described above, the best surface passivation quality (lowest SRV) was obtained for films deposited at a 1:3 dilution ratio. In order to further increase the passivation quality, a hydrogen plasma treatment was performed after deposition of the film. The plasma treatment was done at 0.06 W/cm² for different exposure times. Figure 10 shows the measured SRV values for a film deposited with a hydrogen dilution of 1:3, for different hydrogen plasma exposure times after deposition. It can be seen that the best passivation quality was obtained for a 45s hydrogen plasma exposure. The thickness of these films was in the range between 4 nm and 5 nm. Thus, for a 4 nm to 5 nm thick i-a-Si:H film, an SRV of 5.38 cm/s was obtained.

## Claims

1. A method for fabricating a heterojunction photovoltaic cell, comprising
- providing a crystalline silicon substrate,
- providing a thin passivation layer on a first main surface of said substrate;
- performing a plasma treatment, comprising treating said thin passivation layer with a hydrogen plasma;
- providing a second layer on said thin passivation layer, said second layer comprising amorphous silicon;
**characterized in that** said plasma treatment is performed before providing said second layer.

2. A method according to claim 1, wherein a further plasma treatment is performed after providing said second layer.

3. A method according to any of the previous claims, wherein said thin passivation layer comprises intrinsic hydrogenated amorphous silicon.

4. A method according to any of claims 1 to 2, wherein said thin passivation layer comprises SiON and/orSiOₓ(x=1,2) and/or SiC.

5. A method according to any of the previous claims, wherein the thickness of said thin passivation layer after plasma treatment is less than 100 nm.

6. A method according to claim 5, wherein said thickness of said thin passivation layer after plasma treatment is between 1 and 10 nm.

7. A method according to any of the previous claims, wherein providing said thin passivation layer comprises growing said thin passivation layer, and
wherein growing said thin passivation layer comprises a plasma enhanced CVD process.

8. A method according to claim 7, comprising growing said thin passivation layer by using a silicon precursor gas comprisingSiH₄, SiH₂Cl₂, SiHCl₃, or SiCl₄.

9. A method according to claim 8, wherein said silicon precursor gas is diluted in H₂.

10. A method according to claim 9, wherein said dilution ratio between the silicon precursor and the hydrogenis comprised within the range 1:2 to 1:6.

11. A method according to any of the previous claims, wherein providing said thin passivation layer on a first main surface of said substrate and performing said plasma treatment are performed within the same vacuum chamber, without breaking a vacuum in said vacuum chamber.

12. A method according to any of said previous claims, wherein a duration of said plasma treatment is comprised within the range of 10 to 120 seconds.

13. A method according to any of said previous claims, wherein a power density of said plasma treatment is comprised within the range of 0.01 to 0.5 W/cm².

14. A method according to any of the previous claims, wherein said first main surface corresponds to a front surface of said photovoltaic cell, the second layer corresponding to an emitter layer of said photovoltaic cell.

15. A method according to any of the previous claims, wherein said first main surface corresponds to a back surface of said photovoltaic cell, the second layer corresponding to a back surface field layer.

## Patentansprüche

1. Verfahren zum Erzeugen einer Heteroübergang-Solarzelle, umfassend
- Bereitstellen einer kristallinen Siliziumträgerschicht,
- Bereitstellen einer dünnen Passivierungsschicht auf einer ersten Hauptfläche der Trägerschicht;
- Ausführen einer Plasmabehandlung, umfassend ein Behandeln der dünnen Passivierungsschicht mit einem Wasserstoffplasma;
- Bereitstellen einer zweiten Schicht auf der dünnen Passivierungsschicht, wobei die zweite Schicht amorphes Silizium umfasst;
**dadurch gekennzeichnet, dass** die Plasmabehandlung vor Bereitstellen der zweiten Schicht ausgeführt wird.

2. Verfahren nach Anspruch 1, wobei eine weitere Plasmabehandlung nach Bereitstellen der zweiten Schicht ausgeführt wird.

3. Verfahren nach einem der vorangehenden Ansprüche, wobei die dünne Passivierungsschicht spezifisches hydriertes, amorphes Silizium umfasst.

4. Verfahren nach einem der Ansprüche 1 bis 2, wobei die dünne Passivierungsschicht SiON und/oder SiOₓ(x=1,2) und/oder SiC umfasst.

5. Verfahren nach einem der vorangehenden Ansprüche, wobei die Dicke der dünnen Passivierungsschicht nach Plasmabehandlung weniger als 100 nm ist.

6. Verfahren nach Anspruch 5, wobei die Dicke der dünnen Passivierungsschicht nach Plasmabehandlung zwischen 1 und 10 nm ist.

7. Verfahren nach einem der vorangehenden Ansprüche, wobei das Bereitstellen der dünnen Passivierungsschicht ein Züchten der dünnen Passivierungsschicht umfasst und
wobei das Züchten der dünnen Passivierungsschicht einen plasmaverstärkten chemischen Gasphasenabscheidungs- (CVD-) Prozess umfasst.

8. Verfahren nach Anspruch 7, umfassend ein Züchten der dünnen Passivierungsschicht durch Verwenden eines Siliziumvorläufergases, umfassend SiH₄, SiH₂Cl₂, SiHCl₃ oder SiCl₄.

9. Verfahren nach Anspruch 8, wobei das Siliziumvorläufergas in H₂ verdünnt ist.

10. Verfahren nach Anspruch 9, wobei das Verdünnungsverhältnis zwischen dem Siliziumvorläufergas und dem Wasserstoff im Bereich von 1:2 bis 1:6 liegt.

11. Verfahren nach einem der vorangehenden Ansprüche, wobei das Bereitstellen der dünnen Passivierungsschicht auf einer ersten Hauptfläche der Trägerschicht und Ausführen der Plasmabehandlung innerhalb derselben Vakuumkammer ausgeführt werden, ohne ein Vakuum in der Vakuumkammer zu unterbrechen.

12. Verfahren nach einem der vorangehenden Ansprüche, wobei eine Dauer der Plasmabehandlung im Bereich von 10 bis 120 Sekunden liegt.

13. Verfahren nach einem der vorangehenden Ansprüche, wobei eine Leistungsdichte der Plasmabehandlung im Bereich von 0,01 bis 0,5 W/cm² liegt.

14. Verfahren nach einem der vorangehenden Ansprüche, wobei die erste Hauptfläche einer Stirnfläche der Solarzelle entspricht, die zweite Schicht einer Emitterschicht der Solarzelle entspricht.

15. Verfahren nach einem der vorangehenden Ansprüche, wobei die erste Hauptfläche einer Rückfläche der Solarzelle entspricht, die zweite Schicht einer Rückflächenfeldschicht entspricht.

## Revendications

1. Une méthode pour fabriquer une cellule photovoltaïque à hétérojonction, comprenant de:
- fournir un substrat de silicium cristallin,
- fournir une couche mince de passivation sur une première surface principale dudit substrat;
- réaliser un traitement par plasma, comprenant de traiter ladite couche mince de passivation avec un plasma d'hydrogène;
- fournir une seconde couche sur ladite couche mince de passivation, ladite seconde couche comprenant du silicium amorphe;
**caractérisée en ce que** ledit traitement par plasma est réalisé avant de fournir ladite seconde couche.

2. Une méthode selon la revendication 1, dans laquelle un traitement supplémentaire par plasma est réalisé après la fourniture de ladite seconde couche.

3. Une méthode selon l'une quelconque des revendications précédentes, dans laquelle ladite couche mince de passivation comprend du silicium amorphe hydrogéné intrinsèque.

4. Une méthode selon l'une quelconque des revendications 1 à 2, dans laquelle ladite couche mince de passivation comprend du SiON et/ou du SiOx (x=1, 2) et/ou du SiC.

5. Une méthode selon l'une quelconque des revendications précédentes, dans laquelle l'épaisseur de ladite couche mince de passivation après traitement par plasma est inférieure à 100 nm.

6. Une méthode selon la revendication 5, dans laquelle ladite épaisseur de ladite couche mince de passivation après traitement par plasma est entre 1 et 10 nm.

7. Une méthode selon l'une quelconque des revendications précédentes, dans laquelle fournir ladite couche mince de passivation comprend de faire croître ladite couche mince de passivation, et
dans laquelle faire croître ladite couche mince de passivation comprend un processus de CVD assisté par plasma.

8. Une méthode selon la revendication 7, comprenant de faire croître ladite couche mince de passivation en utilisant un gaz précurseur de silicium comprenant SiH₄, SiH₂Cl₂, SiHCl₃, ou SiCl₄.

9. Une méthode selon la revendication 8, dans laquelle ledit gaz précurseur de silicium est dilué dans H₂.

10. Une méthode selon la revendication 9, dans laquelle ledit rapport de dilution entre le précurseur de silicium et l'hydrogène est compris dans la plage de 1:2 et 1:6.

11. Une méthode selon l'une quelconque des revendications précédentes, dans laquelle fournir ladite couche mince de passivation sur une première surface principale du substrat et réaliser ledit traitement par plasma sont réalisés au sein de la même chambre à vide, sans casser le vide dans ladite chambre à vide.

12. Une méthode selon l'une quelconque des revendications précédentes, dans laquelle une durée dudit traitement par plasma est comprise dans la plage de 10 à 120 secondes.

13. Une méthode selon l'une quelconque des revendications précédentes, dans laquelle une densité de puissance dudit traitement par plasma est comprise dans la plage de 0,01 à 0,5 W/cm².

14. Une méthode selon l'une quelconque des revendications précédentes, dans laquelle ladite première surface principale correspond à une surface avant de ladite cellule photovoltaïque, la seconde couche correspondant à une couche émettrice de ladite cellule photovoltaïque.

15. Une méthode selon l'une quelconque des revendications précédentes, dans laquelle ladite première surface principale correspond à une surface arrière de ladite cellule photovoltaïque, la seconde couche correspondant à une couche de champ de surface arrière.
